# EUROPEAN PATENT APPLICATION

(11) **EP 1 947 699 A1**
(43) Date of publication of application: **23.07.2008**
(21) Application number: 05785935.7
(22) Date of filing: 21.09.2005
(51) Int. Cl.: H01L 29/78

(54) **TRENCH GATE POWER MOSFET**

(71) Applicant: SHINDENGEN ELECTRIC MANUFACTURING COMPANY, LIMITED, Tokyo, 100-0004 (JP)
(72) Inventor: TAKEMORI, Toshiyuki, Hanno-shi, Saitama 357-8585 (JP); WATANABE, Yuji, Hanno-shi Saitama 357-8585 (JP); SASAOKA, Fuminori, Hanno-shi, Saitama 357-8585 (JP); MATSUYAMA, Kazushige, Hanno-shi, Saitama 357-8585 (JP); OSHIMA, Kunihiko, Hanno-shi, Saitama 357-8585 (JP); ITOI, Masato, Hanno-shi, Saitama 357-8585 (JP)
(74) Representative: Bongiovanni, Simone
(86) International application number: PCT/JP2005/017417
(87) International publication number: WO 2007/034547

(57) **Abstract**

A trench gate power MOSFET (1) of the present invention includes an n-type epitaxial layer (12), gates (18) and MOSFET cells. The gate (18) is disposed in a trench (14) formed in a surface of the n-type epitaxial layer (12). The MOSFET cell is formed on the surface of the n-type epitaxial layer (12) so as to be in contact with side surfaces of the trench (14) . The trench gate power MOSFET (1) further includes a p-type isolation region (26) formed on the surface of the n-type epitaxial layer (12) and disposed between the MOSFET cells adj acent to each other in the extending direction of the trench (14) out of the MOSFET cells, and has a pn-junction diode formed between the p-type isolation region (26) and the n-type epitaxial layer (12). According to the trench gate power MOSFET (1) of the present invention, the increase of a diode leakage current with the elevation of temperature can be suppressed.

## Description

### Technical Field

The present invention relates to a trench gate power MOSFET and a manufacturing method thereof.

### Background Art

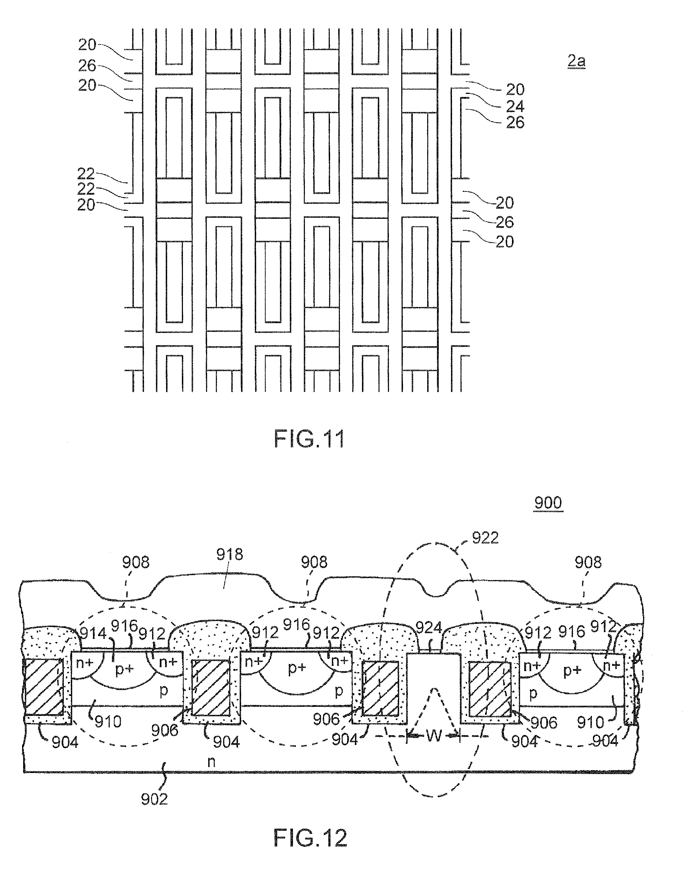

Fig. 12 is a cross-sectional view of a conventional trench gate power MOSFET 900. As shown in Fig. 12, the conventional trench gate power MOSFET 900 includes an n-type semiconductor base body 902, gates 906 disposed in trenches 904 formed in a surface of the n-type semiconductor base body 902, and MOSFET cells 908 respectively formed between the trenches 904. The MOSFET cell 908 includes a p-type body region 910 formed on the surface of the n-type semiconductor base body 902 in a state that the body region 910 is in contact with side surfaces of the trench 904, an n-type source region 912 formed on the surface of the p-type body region 910 in a state that the n-type source region 912 is in contact with the side surfaces of the trench 904, and a p-type contact region 914 formed on the surface of the p-type body region 910 in a state that the p-type contact region 914 is in contact with the n-type source region 912. A conductive layer 916 is formed over the MOSFET cells 908, and a source electrode 918 is formed over the conductive layer 916. A drain electrode 920 (not shown in the drawing) is formed on a back surface of the n-type semiconductor base body 902.

In the conventional trench gate power MOSFET 900 having such a constitution, in a region constituting a portion of a region between the trenches 904, a region 922 where the MOSFET cell is not formed exists, and a metal layer 924 which is electrically connected with the source electrode 918 is formed on the surface of the semiconductor base body 902 in such a region 922. The metal layer 924 and the conductive layer 916 are formed using the same steps and the same material. On an interface between the metal layer 924 and the n-type semiconductor base body 902, a Schottky diode which possesses a parallel relationship with the MOSFET is formed (see patent document 1, for example).

Due to such a constitution, according to the conventional trench gate power MOSFET 900, when the source electrode 918 is positively biased, an electric current flows into the drain electrode 920 from the source electrode 918 via the metal layer 924 and the n-type semiconductor base body 902 and hence, the trench gate power MOSFET 900 exhibits an advantageous effect that a forward drop voltage VF of an incorporated diode can be suppressed to a low level when the MOSFET is used in the bridge structure.

Further, according to the conventional trench gate power MOSFET 900, such a Schottky barrier diode can be integrated into the trench gate power MOSFET in a monolithic manner and hence, the trench gate power MOSFET 900 also acquires an advantageous effect that a product can be miniaturized compared to a case where a Schottky barrier diode is externally mounted on a power MOSFET.

Patent document 1: US Patent Specification No. 6351018 (Fig. 1 and Fig. 2)

### Disclosure of the Invention

### Problems that the Invention is to Solve

However, the conventional trench gate power MOSFET 900 has a drawback that a diode leakage current attributed to the Schottky barrier diode is increased along with the elevation of temperature.

The present invention has been made to overcome the above-mentioned drawbacks, and it is an object of the present invention to provide a trench gate power MOSFET capable of suppressing the increase of a diode leakage current attributed to the elevation of temperature.

### Means for Solving the Problems

A trench gate power MOSFET includes: a first conductive-type semiconductor base body; gates disposed in trenches formed in a surface of the first conductive-type semiconductor base body; and MOSFET cells including second conductive-type body regions formed on the surface of the first conductive-type semiconductor base body in a state that the second conductive-type body regions are in contact with side surfaces of the trenches, first conductive-type source regions formed on surfaces of the second conductive-type body regions in a state that the first conductive-type source regions are in contact with the side surfaces of the trenches, and second conductive-type contact regions formed on the surfaces of the second conductive-type body regions in a state that the second conductive-type contact regions are in contact with the first conductive-type source regions, wherein the trench gate power MOSFET further includes second conductive-type isolation regions which are formed on the surface of the first conductive-type semiconductor base body and are disposed such that each second conductive-type isolation region is disposed between the MOSFET cells adjacent to each other in the extending direction of the trenches out of the MOSFET cells, and a pn-junction diode is formed between the second conductive-type isolation region and the first conductive-type semiconductor base body.

Due to such a constitution, according to the trench gate power MOSFET of the present invention, the pn-junction diode is integrated to the trenchgatepowerMOSFET inplace of a Schottky barrier diode and hence, it is possible to suppress the increase of a diode leakage current attributed to the elevation of temperature.

Further, according to the trench gate power MOSFET of the present invention, the second conductive-type isolation regions are formed in addition to the second conductive-type body regions, and the pn-junction diode is formed between the second conductive-type isolation region and the first conductive-type semiconductor base body and hence, a depth and the impurity concentration of the second conductive-type isolation region can be determined independently from the second conductive-type body region thus ensuring a required withstand voltage.

Further, according to the trench gate power MOSFET of the present invention, the second conductive-type isolation region is disposed between the MOSFET cells adjacent to each other in the extending direction of the trenches, and the pn-junction diode is formed between the second conductive-type isolation region and the first conductive-type semiconductor base body and hence, by forming a portion of a MOSFET-cell-forming region defined between the trenches into the second conductive-type isolation region, an area on which the pn-junction diode is formed can be reduced thus preventing an ON resistance from being increased more than necessity.

Still further, according to the trench gate power MOSFET of the present invention, the second conductive-type isolation region is disposed between the MOSFET cells adjacent to each other in the extending direction of the trenches and hence, positioning of a mask in a step for forming the second conductive-type isolation regions does not require considerably high positioning accuracy thus preventing the MOSFET cell from becoming large-sized or a process from becoming complicated attributed to the formation of the second conductive-type isolation regions.

In the trench gate power MOSFET of the present invention, the impurity concentration in the surface of the second conductive-type isolation region may preferably be set lower than the impurity concentration in the surface of the second conductive-type body region.

In the trench gate power MOSFET of the present invention, a depth of the second conductive-type isolation region may preferably be smaller than a depth of the second conductive-type body region.

In the trench gate power MOSFET of the present invention, a total quantity of impurity integrated in the depth direction in the second conductive-type isolation region may preferably be set smaller than a total quantity of impurity integrated in the depth direction in the second conductive-type body region.

Due to such constitutions, the trench gate power MOSFET of the present invention can form the pn-junction diode with a low forward drop voltage.

In the trench gate power MOSFET of the present invention, the impurity concentration in the surface of the second conductive-type isolation region may preferably be set to a value equal to or more than 5×10¹⁶ atoms/cm³.

In the trench gate power MOSFET of the present invention, the depth of the second conductive-type isolation region may preferably be set to a value equal to or more than 0.28µm.

Due to such a constitution, the trench gate power MOSFET of the present invention can form the pn-junction diode with a small leakage current.

In the trench gate power MOSFET of the present invention, a source electrode which is formed so as to cover the first conductive-type source regions, the second conductive-type body regions and the second conductive-type isolation regions may preferably be made of a metal material containing tervalent metal in a state that the first conductive-type is set to an n type.

Due to such a constitution, a favorable electrical connection can be established between the first conductive-type source region and the source electrode, between the second conductive-type body region and the source electrode, and between the second conductive-type isolation region and the source electrode.

In the trench gate power MOSFET of the present invention, the second conductive-type body region maypreferablybe disposed between the first conductive-type source region and the second conductive-type isolation region.

Due to such a constitution, the second conductive-type body region always exists around the first conductive-type source region and hence, there is no possibility that the transistor characteristics are deteriorated attributed to the formation of the second conductive-type isolation region.

In the trench gate power MOSFET of the present invention, the first conductive-type semiconductor base body may preferably be a first conductive-type epitaxial layer formed on a surface of a semiconductor substrate.

Due to such a constitution, by optimizing the impurity concentration and a layer thickness of the first conductive-type epitaxial layer, it is possible to acquire a trench gate power MOSFET possessing the desired ON resistance characteristic and the desired withstand voltage characteristic.

### Brief Description of the Drawings

Fig. 1 is a view for explaining a trench gate power MOSFET 1 according to an embodiment 1;
Fig. 2 is a perspective view of the trench gate power MOSFET 1 according to the embodiment 1;
Fig. 3 is a view showing an impurity concentration profile in the depth direction in the trench gate power MOSFET 1;
Fig. 4 is a view showing leakage current density when conditions for forming a p-type isolation region 26 are changed;
Fig. 5 is a view showing a forward drop voltage VF when conditions for forming the p-type isolation region 26 are changed;
Fig. 6 is a view showing respective manufacturing steps of a manufacturing method of the trench gate power MOSFET 1 according to the embodiment 1;
Fig. 7 is a view showing respective manufacturing steps of a manufacturing method of the trench gate power MOSFET 1 according to the embodiment 1;
Fig. 8 is a plan view of a trench gate power MOSFET 1a according to a modification (modification 1) of the embodiment 1;
Fig. 9 is a view for explaining a trench gate power MOSFET 2 according to an embodiment 2;
Fig. 10 is a perspective view of the trench gate power MOSFET 2 according to the embodiment 2;
Fig. 11 is a plan view of the trench gate power MOSFET 2a according to amodification (modification 2) of the embodiment 2; and
Fig. 12 is a cross-sectional view of a conventional trench gate power MOSFET 900.

### Best Mode for Carrying Out the Invention

Embodiments of the present invention are explained in detail in conjunction with drawings hereinafter.

### [Embodiment 1]

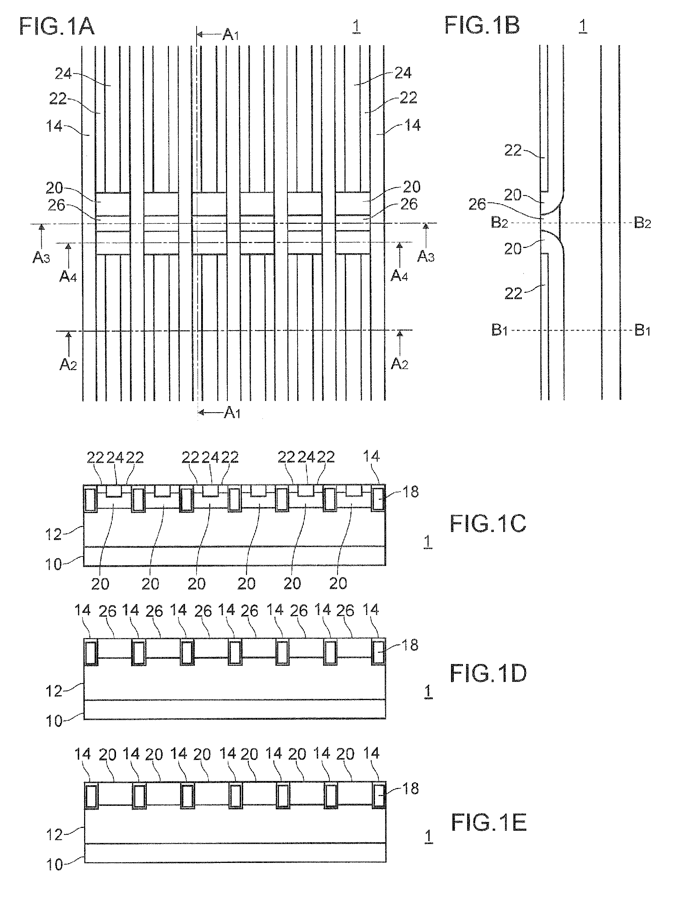

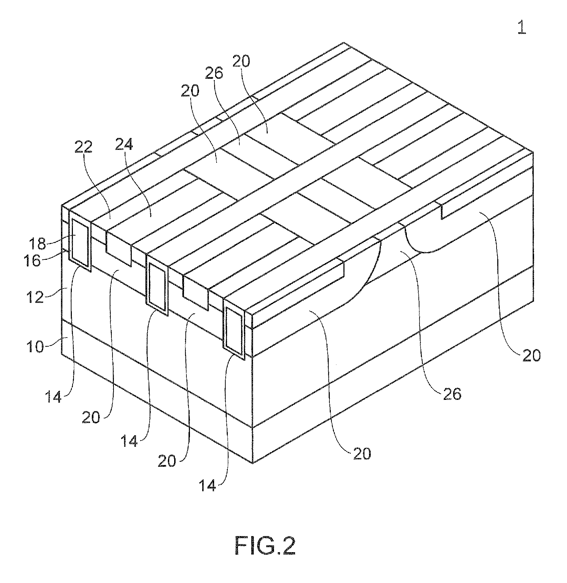

Fig. 1 is a view for explaining a trench gate power MOSFET 1 according to an embodiment 1. Fig. 1(a) is a plan view of the trench gate power MOSFET 1, Fig. 1(b) is a cross-sectional view taken along a line A₁-A₁ in Fig. 1(a), Fig. 1(c) is a cross-sectional view taken along a line A₂-A₂ in Fig. 1(a), Fig. 1 (d) is a cross-sectional view taken along a line A₃-A₃ in Fig. 1 (a), and Fig. 1 (e) is a cross-sectional view taken along a line A₄-A₄ in Fig. 1 (a). Fig. 2 is a perspective view of the trench gate power MOSFET 1 according to the embodiment 1.

The trench gate power MOSFET 1 according to the embodiment 1 includes, as shown in Fig. 1 and Fig. 2, an n-type epitaxial layer 12 (first conductive-type semiconductor base body) formed on an n-type silicon substrate 10, gates 18 disposed in trenches 14 formed in a surface of the n-type epitaxial layer 12, and a MOSFET cell including p-type body regions 20 (second conductive-type body regions) formed on the surface of the n-type epitaxial layer 12 in a state that the p-type body region 20 is in contact with side surfaces of the trenches 14, n-type source regions 22 (first conductive-type source regions) formed on the surfaces of the p-type body regions 20 in a state that the n-type source regions 22 are in contact with the side surfaces of the trenches 14, and p-type contact regions 24 (second conductive-type contact regions) formed on the surfaces of the p-type body regions 20 in a state that the p-type contact regions 24 are in contact with the n-type source regions 22.

The trench gate power MOSFET 1 according to the embodiment 1 further includes p-type isolation regions 26 (second conductive-type isolation regions) each of which is formed on the surface of the n-type epitaxial layer 12 and is disposed between the MOSFET cells adjacent to each other in the extending direction of the trenches 14 out of the MOSFET cells, and a pn-junction diode is formed between the p-type isolation region 26 and the n-type epitaxial layer 12.

In the trench gate power MOSFET 1 according to the embodiment 1, as shown in Fig. 1 (b) and Fig. 2, the p-type body region 20 is disposed between the n-type source region 22 and the p-type isolation region 26.

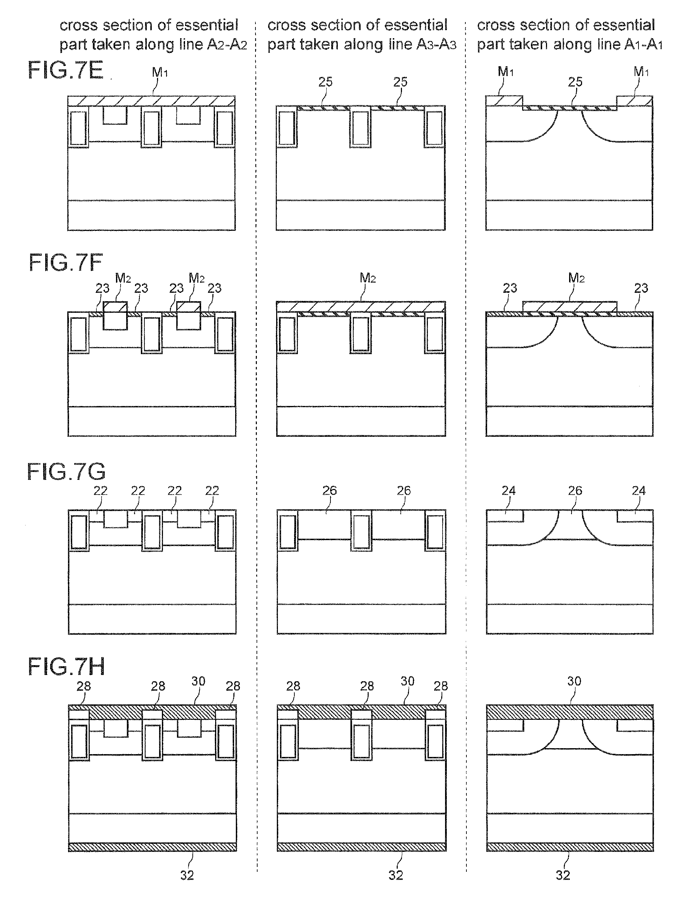

In the trench gate power MOSFET 1 according to the embodiment 1, a source electrode 30 is formed so as to cover the n-type source regions 22, the p-type contact regions 24 and thep-type isolation regions 26 (see Fig. 7(h)). Here, the source electrode 30 is made of aluminum.

According to the trench gate power MOSFET 1 of the embodiment 1 having the above-mentioned constitution, the pn-junction diode is integrated to the trench gate power MOSFET in place of a Schottky barrier diode and hence, it is possible to suppress the increase of a diode leakage current attributed to the elevation of temperature.

Further, according to the trench gate power MOSFET 1 of the embodiment 1, the p-type isolation regions 26 are formed in addition to the p-type body regions 20, and the pn-junction diode is formed between the p-type isolation region 26 and the n-type epitaxial layer 12 and hence, a depth and impurity concentration of the p-type isolation region 2 6 can be determined independently from the p-type body region 20 thus ensuring a required withstand voltage.

Further, according to the trench gate power MOSFET 1 of the embodiment 1, the p-type isolation region 26 is disposed between the MOSFET cells adjacent to each other in the extending direction of the trenches 14, and the pn-junction diode is formed between the p-type isolation region 26 and the n-type epitaxial layer 12 and hence, by forming a portion of a MOSFET-cell-forming region defined between the trenches 14 into the second conductive-type isolation region 26, an area on which the pn-junction diode is formed can be reduced thus preventing an ON resistance from being increased more than necessity.

Further, according to the trench gate power MOSFET 1 of the embodiment 1, the p-type isolation region 26 is disposed between the MOSFET cells adjacent to each other in the extending direction of the trenches 14 and hence, positioning of a mask in a step for forming the p-type isolation regions 26 does not require considerably high positioning accuracy thus preventing the MOSFET cell from becoming large sized or a process from becoming complicated attributed to the formation of the p-type isolation regions 26.

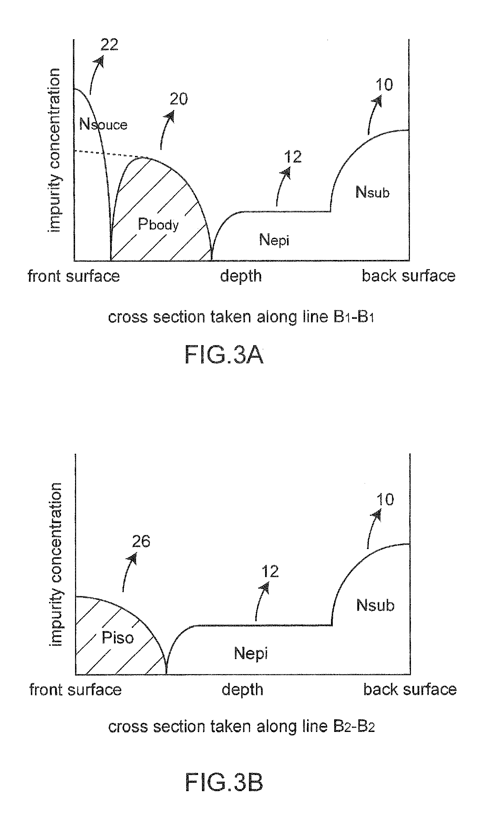

Fig. 3 is a view showing an impurity concentration profile in the depth direction in the trench gate power MOSFET 1. Fig. 3(a) is a view showing the impurity concentration profile in cross section taken along a line B₁-B₁ in Fig. 1(b), and Fig. 3(b) is a view showing the impurity concentration profile in cross section taken along a line B₂-B₂ in Fig. 1(b).

In the trench gate power MOSFET 1 of the embodiment 1, as shown in Fig. 3, the impurity concentration (see Fig. 3 (b), for example, 5x10¹⁶ atoms/cm³) in the surface of the p-type isolation region 26 is lower than the impurity concentration (see Fig. 3(a), for example, 3×10¹⁷ atoms/cm³) in the surface of the p-type body region 20.

Further, in the trench gate power MOSFET 1 of the embodiment 1, as shown in Fig. 3, Fig. 1 (b) and Fig. 2, a depth (for example, 0.3µm) of the p-type isolation region 26 is smaller than a depth (for example, 1.0µm) of the p-type body region 20.

Further, in the trench gate power MOSFET 1 of the embodiment 1, as shown in Fig. 3, a total quantity of impurity integrated in the depth direction in the p-type isolation region 26 is smaller than a total quantity of impurity integrated in the depth direction in the p-type body region 20.

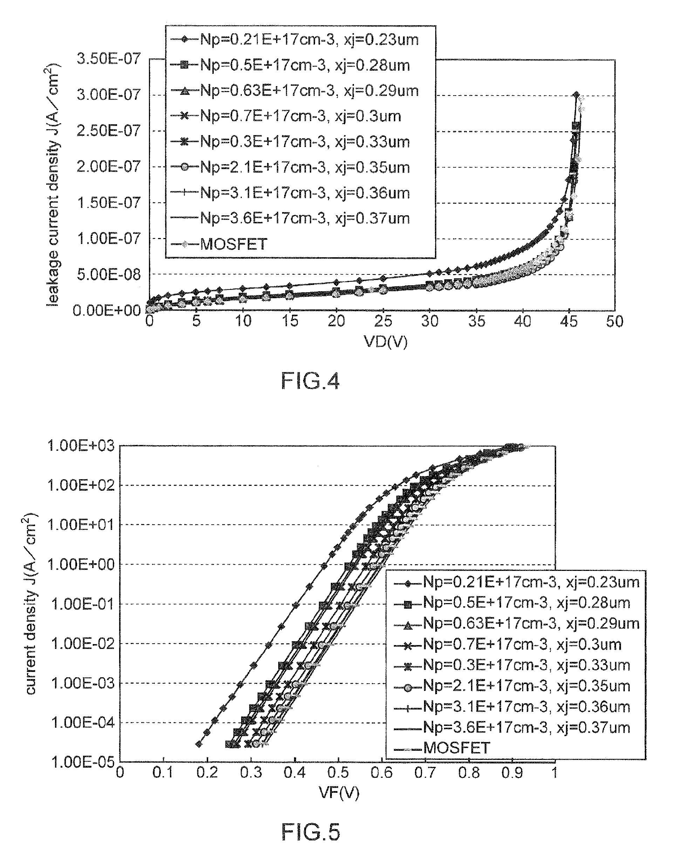

Fig. 4 is a view showing leakage current density when conditions for forming the p-type isolation region 26 are changed. A drain voltage VD is taken on an axis of abscissas, and the leakage current density J is taken on an axis of ordinates. Symbol Np indicates surface impurity concentration of the p-type isolation region 26, and symbol xj indicates a depth of the p-type isolation region 26.

As shown in Fig. 4, it is understood that the leakage current density J of the trench gate power MOSFET 1 of the embodiment 1 is not increased except for a case in which the impurity concentration of the p-type isolation region is extremely low (2.1×10¹⁶ atoms/cm³) and the depth of the isolation region is extremely small (0.23µm).

Fig. 5 is a view showing a forward drop voltage VF when conditions for forming the p-type isolation region 26 are changed. The forward drop voltage VF is taken on an axis of abscissas, and the current density J corresponding to the forward drop voltage VF is taken on an axis of ordinates. Symbol Np indicates surface impurity concentration of the p-type isolation region 26, and symbol xj indicates a depth of the p-type isolation region 26.

As shown in Fig. 5, it is understood that the forward drop voltage VF of the trench gate power MOSFET 1 of the embodiment 1 is lowered corresponding to the decrease of the impurity concentration of the p-type isolation region and the decrease of the depth of the p-type isolation region.

Accordingly, in the trench gate power MOSFET 1 of the embodiment 1, as can be understood from Fig. 3 to Fig. 5, it is preferable to set the impurity concentration in the surface of the p-type isolation region 26 lower than the impurity concentration in the surface of the p-type body region 20 and, at the same time, to set the impurity concentration in the surface of the p-type isolation region 26 to a value equal to or more than 5x10¹⁶ atoms/cm³. Further, it is preferable to set the depth of the p-type isolation region 26 smaller than the depth of the p-type body region 20 and, at the same time, to set the depth of the p-type isolation region 26 to a value equal to or more than 0.28µm. Further, it is preferable to set the total quantity of the impurity integrated in the depth direction in the p-type isolation region 26 smaller than the total quantity of the impurity integrated in the depth direction in the p-type body region 20.

By setting the impurity concentration, the depth and the total quantity of the impurity in the p-type isolation region 26 to values which fall within the above-mentioned ranges, it is possible to form a pn-junction diode which exhibits a small leakage current and a low forward drop voltage.

In the trench gate power MOSFET 1 of the embodiment 1, the source electrode which is formed so as to cover the n-type source regions 22, the p-type contact regions 24 and the p-type isolation regions 26 is made of aluminum as described above and hence, a favorable electrical connection is established between these regions 22, 24, 26 and the source electrode 30.

In the trench gate power MOSFET 1 of the embodiment 1, the p-type body region 20 is disposed between the n-type source region 22 and the p-type isolation region 26 and hence, the p-type body region 20 always exists around the n-type source region 22 whereby there is no possibility that the transistor characteristics are deteriorated attributed to the formation of the p-type isolation region 26.

In the trench gate power MOSFET 1 of the embodiment 1, the n-type epitaxial layer 12 formed on the surface of the silicon substrate 10 is used as the first conductive-type semiconductor base body and hence, by optimizing impurity concentration and a layer thickness of the n-type epitaxial layer 10, it is possible to acquire a trench gate power MOSFET possessing desired ON resistance characteristic and withstand voltage characteristic.

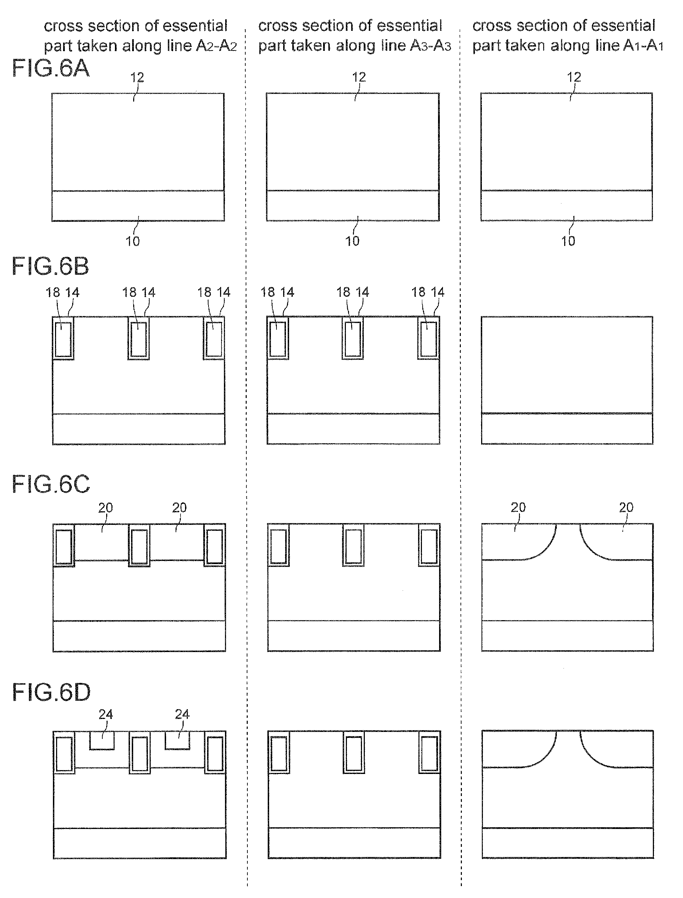

A manufacturing method of the trench gate power MOSFET 1 according to the embodiment 1 is explained. Fig. 6 and Fig. 7 are views showing respective manufacturing steps of the manufacturing method of the trench gate power MOSFET according to the embodiment 1. In Fig. 6 and Fig. 7, in respective steps (a) to (h), essential parts in cross section taken along lines A₂-A₂, A₃-A₃ and A₁-A₁ in Fig. 1 (a) are shown.

The manufacturing method of the trench gate power MOSFET 1 according to the embodiment 1 includes, as shown in Fig. 6 and Fig. 7, following steps ranging from (a) a first step to (h) an eighth step in this order.

### (a) First step

The n-type silicon substrate 10 which forms the n-type epitaxial layer 12 on an upper surface thereof is prepared (see Fig. 6 (a)). The impurity concentration of the n-type epitaxial layer 12 is set to 3×10⁺¹⁵ atoms/cm³, for example.

### (b) Second step

Next, a silicon oxide film is selectively formed on a surface of the n-type epitaxial layer 12, and the trenches 14 are formed in the surface of the n-type epitaxial layer 12 using the silicon oxide film as a mask. After removing the silicon oxide film, the gate insulation film 16 is formed by thermal oxidation. Thereafter, the inside of the trench is filled with poly-silicon doped with phosphorous, an upper surface of poly-silicon is etched back and is subject to further thermal oxidation thus forming the gates 18 (see Fig. 6(b)). Here, a surface of the epitaxial layer 12 is leveled.

### (c) Third step

Next, for example, boron ions (for example, 1.5×10⁺¹³ atoms/cm²) are implanted into the n-type epitaxial layer 12 except for portions corresponding to the p-type isolation regions 26 and, thereafter, thermal annealing is applied (for example, at a temperature of 1100°C for 45 minutes) thus forming the p-type body regions 20 (see Fig. 6(c)).

### (d) Fourth step

Next, for example, boron ions (for example, 2x10⁺¹⁵ atoms/cm²) are implanted into portions of the n-type epitaxial layer 12 corresponding to the p-type contact regions 24 and, thereafter, thermal annealing is applied (for example, at a temperature of 900°C for 30 minutes) thus forming the p-type contact regions 24 (see Fig. 6(d)).

### (e) Fifth step

Next, for example, boron ions (for example, 1.7x10⁺¹² atoms/cm²) are implanted into portions 25 of the n-type epitaxial layer 12 corresponding to the p-type isolation region 26 (see Fig. 7(e)). Here, in Fig. 7(e), symbol M₁ indicates a mask.

### (f) Sixth step

Next, for example, arsenic ions (for example, 4x10⁺¹⁵ atoms/cm²) are implanted into portions 23 of the n-type epitaxial layer 12 corresponding to the n-type source regions 22 (see Fig. 7(f)). A width of the portion 23 corresponding to the n-type source region 22 is set to 1µm or less, for example. Further, a distance between the portion 23 corresponding to the n-type source region 22 and the portion 23 corresponding to the n-type source region 22 is set to 7µm or less, for example. Here, in Fig. 7(f), symbol M₂ indicates a mask.

### (g) Seventh step

Next, after removing the resist, thermal annealing is applied (for example at a temperature of 1000°C for 10 minutes) thus simultaneously forming the p-type isolation regions 26 and the n-type source regions 22 (see Fig. 7(g)).

### (h) Eighth step

Next, interlayer insulation films 28 are formed over the trenches, and the source electrode 30 is formed over the interlayer insulation films 28. Further, a drain electrode 32 is formed on a back surface of the silicon substrate 10 (see Fig. 7(h)).

As described above, according to the manufacturing method of the trench gate power MOSFET of the embodiment 1, the trench gate power MOSFET 1 of the embodiment 1 can be manufactured using the relatively easy method.

### [Modification 1]

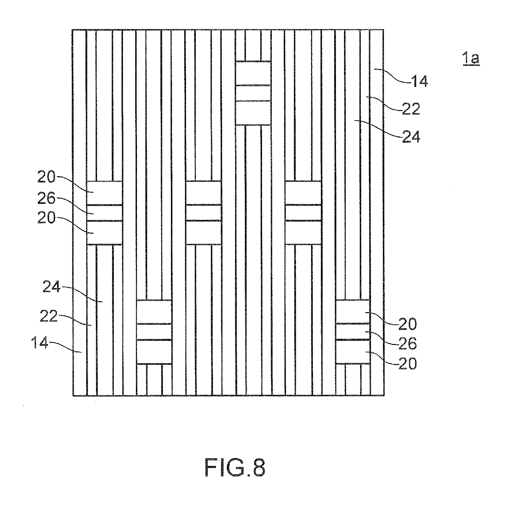

Fig. 8 is a plan view of a trench gate power MOSFET 1a according to a modification 1.
The trench gate power MOSFET 1a according to the modification 1 adopts the structure similar to the structure of the trench gate power MOSFET 1 according to the embodiment 1. However, as shown in Fig. 8, the trench gate power MOSFET 1a according to the modification 1 differs from the trench gate power MOSFET 1 according to the embodiment 1 with respect to a pattern for arranging the p-type isolation regions 26. That is, in the trench gate power MOSFET 1a according to the modification 1, the p-type isolation regions 26 are formed in a more dispersed manner than the p-type isolation regions 26 in the trench gate power MOSFET 1 according to the embodiment 1.

In this manner, the trench gate power MOSFET 1a according to the modification 1 differs from the trench gate power MOSFET 1 according to the embodiment 1 with respect to the pattern for arranging the p-type isolation regions 26. However, in the same manner as the trench gate power MOSFET 1 according to the embodiment 1, the pn-junction diode is integrated to the trench gate power MOSFET in place of a Schottky barrier diode and hence, it is possible to suppress the increase of a diode leakage current attributed to the elevation of temperature.
Further, the p-type isolation regions 26 are formed in addition to the p-type body regions 20, and the pn-junction diode is formed between the p-type isolation region 26 and the n-type epitaxial layer 12 and hence, a depth and impurity concentration of the p-type isolation region 26 can be determined independently from the p-type body region 20 thus ensuring a required withstand voltage.

Further, the p-type isolation region 26 is disposed between the MOSFET cells adjacent to each other in the extending direction of the trenches 14, and the pn-junction diode is formed between the p-type isolation region 26 and the n-type epitaxial layer 12 and hence, by forming a portion of a MOSFET-cell-forming region defined between the trenches 14 into the p-type isolation region 26, an area on which the pn-junction diode is formed can be reduced thus preventing an ON resistance from being increased more than necessity.
Still further, the p-type isolation region 26 is disposed between the MOSFET cells adjacent to each other in the extending direction of the trenches 14 and hence, positioning of a mask in a step for forming the p-type isolation regions 26 does not require considerably high positioning accuracy thus preventing the MOSFET cell from becoming large sized or a process from becoming complicated attributed to the formation of the p-type isolation regions 26.

### [Embodiment 2]

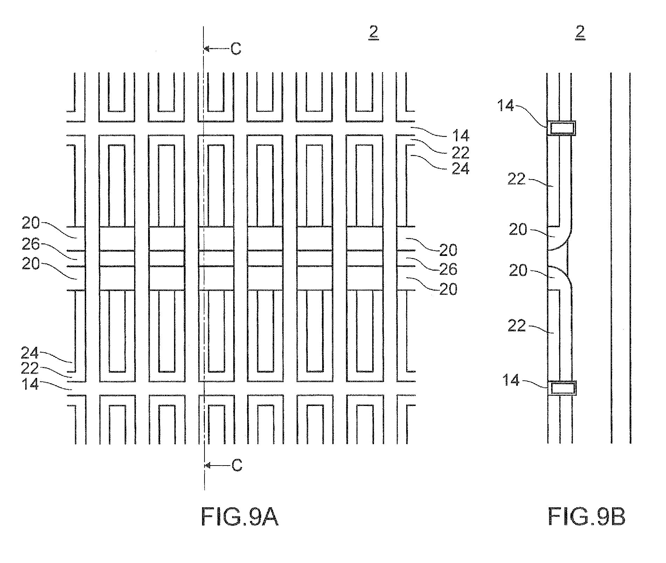

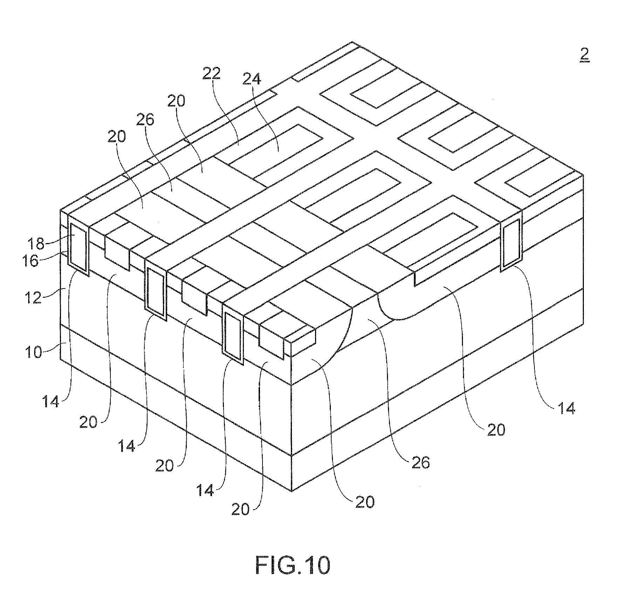

Fig. 9 is a view for explaining a trench gate power MOSFET 2 according to an embodiment 2. Fig. 9(a) is a plan view of the trench gate power MOSFET 2, and Fig. 9 (b) is a cross-sectional view taken along a line C-C in Fig. 9 (a). Fig. 10 is a perspective view of the trench gate power MOSFET 2 according to the embodiment 2.

The trench gate power MOSFET 2 according to the embodiment 2 adopts the structure similar to the structure of the trench gate power MOSFET 1 according to the embodiment 1. However, as shown in Fig. 9 and Fig. 10, the trench gate power MOSFET 2 according to the embodiment 2 differs from the trench gate power MOSFET 1 according to the embodiment 1 with respect to a pattern for forming the trenches 14. That is, in the trench gate power MOSFET 2 according to the embodiment 2, the trenches 14 are formed in a grid arrangement.

In this manner, the trench gate power MOSFET 2 according to the embodiment 2 differs from the trench gate power MOSFET 1 according to the embodiment 1 with respect to the pattern for forming the trenches 14. However, in the same manner as the trench gate power MOSFET 1 according to the embodiment 1, the pn-junction diode is integrated to the trench gate power MOSFET in place of a Schottky barrier diode and hence, it is possible to suppress the increase of a diode leakage current attributed to the elevation of temperature.
Further, the p-type isolation regions 26 are formed in addition to the p-type body regions 20, and the pn-junction diode is formed between the p-type isolation region 26 and the n-type epitaxial layer 12 and hence, a depth and impurity concentration of the p-type isolation region 26 can be determined independently from the p-type body region 20 thus ensuring a required withstand voltage.

Further, the p-type isolation region 26 is disposed between the MOSFET cells adjacent to each other in the extending direction of the trenches 14, and the pn-junction diode is formed between the p-type isolation region 26 and the n-type epitaxial layer 12 and hence, by forming a portion of a MOSFET-cell-forming region defined between the trenches 14 into the p-type isolation region 26, an area on which the pn-junction diode is formed can be reduced thus preventing an ON resistance from being increased more than necessity.
Still further, the p-type isolation region 26 is disposed between the MOSFET cells adjacent to each other in the extending direction of the trenches 14 and hence, positioning of a mask in a step for forming the p-type isolation regions 26 does not require considerably high positioning accuracy thus preventing the MOSFET cell from becoming large sized or a process from becoming complicated attributed to the formation of the p-type isolation regions 26.

### [Modification 2]

Fig. 11 is a plan view of a trench gate power MOSFET 2a according to a modification 2.
The trench gate power MOSFET 2a according to the modification 2 adopts the structure similar to the structure of the trench gate power MOSFET 2 according to the embodiment 2. However, as shown in Fig. 11, the trench gate power MOSFET 2a according to the modification 2 differs from the trench gate power MOSFET 2 according to the embodiment 2 with respect to a pattern for forming the MOSFET cells. That is, in the trench gate power MOSFET 2a according to the modification 2, the MOSFET cells are formed in a staggered arrangement.

In this manner, the trench gate power MOSFET 2a according to the modification 2 differs from the trench gate power MOSFET 2 according to the embodiment 2 with respect to the pattern for forming the MOSFET cells. However, in the same manner as the trench gate power MOSFET 2 according to the embodiment 2, the pn-junction diode is integrated to the trench gate power MOSFET in place of a Schottky barrier diode and hence, it is possible to suppress the increase of a diode leakage current attributed to the elevation of temperature.
Further, the p-type isolation regions 26 are formed in addition to the p-type body regions 20, and the pn-junction diode is formed between the p-type isolation region 26 and the n-type epitaxial layer 12 and hence, a depth and impurity concentration of the p-type isolation region 26 can be determined independently from the p-type body region 20 thus ensuring a required withstand voltage.

Further, the p-type isolation region 26 is disposed between the MOSFET cells adjacent to each other in the extending direction of the trenches 14, and the pn-junction diode is formed between the p-type isolation region 26 and the n-type epitaxial layer 12 and hence, by forming a portion of a MOSFET-cell-forming region defined between the trenches 14 into the p-type isolation region 26, an area on which the pn-junction diode is formed can be reduced thus preventing an ON resistance from being increased more than necessity.
Still further, the p-type isolation region 26 is disposed between the MOSFET cells adjacent to each other in the extending direction of the trenches 14 and hence, positioning of a mask in a step for forming the p-type isolation regions 26 does not require considerably high positioning accuracy thus preventing the MOSFET cell from becoming large sized or a process from becoming complicated attributed to the formation of the p-type isolation regions 26.

Although the trench gate power MOSFET of the present invention has been explained in conjunction with the above-mentioned respective embodiments heretofore, the present invention is not limited to the above-mentioned respective embodiments, and various modifications can be made without departing from the gist of the present invention. For example, the following modification can be made.

(1) In the trench gate power MOSFET 1 according to the embodiment 1, although the source electrode is made of aluminum, the present invention is not limited to the use of aluminum as the material of the source electrode. The source electrode may favorably be made of an AlSiCu alloy or the like.

### Description of the Reference Numerals and Signs

1, 1a, 2, 2a, 900: trench gate power MOSFET, 10: siliconsubstrate, 12: n-type epitaxial layer, 14: trench, 16: gate insulation film, 18: gate, 20: p-type body region, 22: n-type source region, 24: p-type contact region, 26: p-type isolation region, 28: interlayer insulation film, 30: source electrode, 32: drain electrode, M₁, M₂: mask

## Claims

1. A trench gate power MOSFET comprising:
a first conductive-type semiconductor base body;
gates disposed in trenches formed in a surface of the first conductive-type semiconductor base body; and
MOSFET cells including second conductive-type body regions formed on the surface of the first conductive-type semiconductor base body in a state that the second conductive-type body regions are in contact with side surfaces of the trenches, first conductive-type source regions formed on surfaces of the second conductive-type body regions in a state that the first conductive-type source regions are in contact with the side surfaces of the trenches, and second conductive-type contact regions formed on the surfaces of the second conductive-type body regions in a state that the second conductive-type contact regions are in contact with the first conductive-type source regions, wherein
the trench gate power MOSFET further comprises second conductive-type isolation regions which are formed on the surface of the first conductive-type semiconductor base body and are disposed such that each second conductive-type isolation region is disposed between the MOSFET cells adjacent to each other in the extending direction of the trenches out of the MOSFET cells, and
a pn-junction diode is formed between the second conductive-type isolation region and the first conductive-type semiconductor base body.

2. A trench gate power MOSFET according to claim 1, wherein impurity concentration in the surface of the second conductive-type isolation region is set lower than the impurity concentration in the surface of the second conductive-type body region.

3. A trench gate power MOSFET according to claim 1 or 2, wherein a depth of the second conductive-type isolation region is smaller than a depth of the second conductive-type body region.

4. A trench gate power MOSFET according to any one of claims 1 to 3, wherein a total quantity of impurity integrated in the depth direction in the second conductive-type isolation region is set smaller than a total quantity of impurity integrated in the depth direction in the second conductive-type body region.

5. A trench gate power MOSFET according to any one of claims 1 to 4, wherein the impurity concentration in the surface of the second conductive-type isolation region is set to a value equal to or more than 5x10¹⁶ atoms/cm³.

6. A trench gate power MOSFET according to any one of claims 1 to 5, wherein the depth of the second conductive-type isolation region is set to a value equal to or more than 0.28µm.

7. A trench gate power MOSFET according to any one of claims 1 to 6, wherein a source electrode which is formed so as to cover the first conductive-type source regions and the second conductive-type body regions are made of a metal material containing tervalent metal in a state that the first conductive-type is set to an n type.

8. A trench gate power MOSFET according to any one of claims 1 to 7, wherein the second conductive-type body region is disposed between the first conductive-type source region and the second conductive-type isolation region.

9. A trench gate power MOSFET according to any one of claims 1 to 8, wherein the first conductive-type semiconductor base body is a first conductive-type epitaxial layer formed on a surface of a semiconductor substrate.
